# EUROPEAN PATENT SPECIFICATION

(11) **EP 4 479 898 B1**
(45) Date of publication and mention of the grant of the patent: **08.07.2026**
(21) Application number: 22705850.0
(22) Date of filing: 16.02.2022
(51) Int. Cl.: G06N 10/40, H10N 60/12, H10N 69/00, B82Y 10/00

(54) **ARRANGEMENT AND METHOD FOR MAKING A COUPLING TO A QUBIT**
ANORDNUNG UND VERFAHREN ZUR HERSTELLUNG EINER KOPPLUNG AN EIN QUBIT
AGENCEMENT ET PROCÉDÉ DE RÉALISATION D'UN COUPLAGE À UN BIT QUANTIQUE

(43) Date of publication of application: 25.12.2024
(73) Proprietor: IQM Finland Oy, 02150 Espoo (FI)
(72) Inventor: HEIMONEN, Hermanni, 02150 Espoo (FI); LÄHTEENMÄKI, Pasi, 02150 Espoo (FI)
(74) Representative: Papula Oy
(86) International application number: PCT/FI2022/050097
(87) International publication number: WO 2023/156702

(56) References cited:
- CHUI-PING YANG ET AL: "Generating entanglement among microwave photons and qubits in multiple cavities coupled by a superconducting qubit", ARXIV.ORG, CORNELL UNIVERSITY LIBRARY, 201 OLIN LIBRARY CORNELL UNIVERSITY ITHACA, NY 14853, 16 June 2011 (2011-06-16), XP080509632
- ANETTE MESSINGER ET AL: "Left-handed superlattice metamaterials for circuit-QED", ARXIV.ORG, CORNELL UNIVERSITY LIBRARY, 201 OLIN LIBRARY CORNELL UNIVERSITY ITHACA, NY 14853, 8 October 2018 (2018-10-08), XP081058656
- HAO HSU ET AL: "Tunable refrigerator for non-linear quantum electric circuits", ARXIV.ORG, CORNELL UNIVERSITY LIBRARY, 201 OLIN LIBRARY CORNELL UNIVERSITY ITHACA, NY 14853, 16 June 2020 (2020-06-16), XP081686310, DOI: 10.1103/PHYSREVB.101.235422

## Description

### FIELD OF THE INVENTION

The present disclosure relates to quantum computing. More particularly, the present disclosure relates to an arrangement and a method for making a coupling to a qubit so that the strength of the coupling can be defined very effectively with appropriate tuning. Additionally, the present disclosure relates to a quantum computing system.

### BACKGROUND OF THE INVENTION

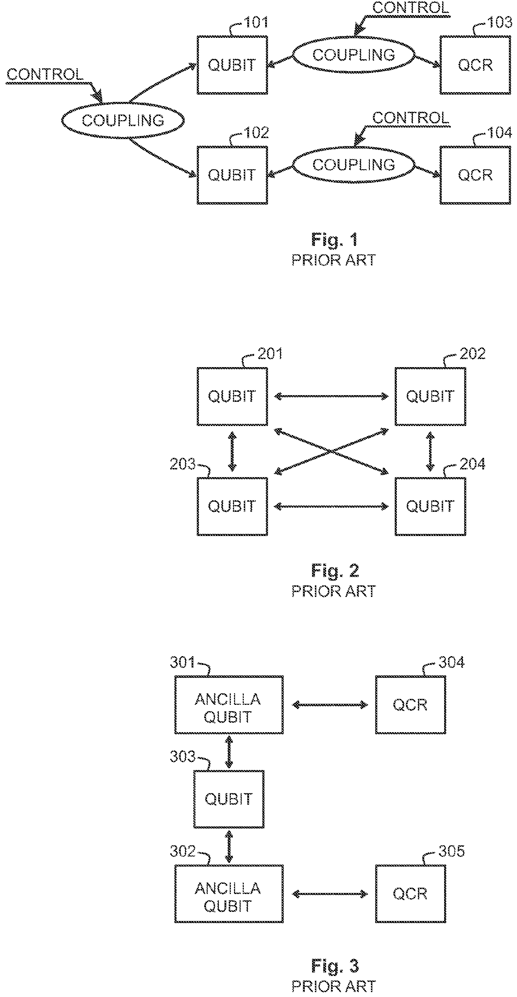

Qubits are the fundamental circuit elements used in quantum computing. Fig. 1 shows an example of qubits 101 and 102. Controllable couplings to qubits are needed for a variety of reasons. One such reason is the need to controllably reset a qubit by coupling it to a quantum circuit refrigerator (QCR) that will absorb the energy in the qubit and make it acquire its ground state; see QCR's 103 and 104 respectively. In some cases, one may want to initialise a qubit to a thermal state by coupling it to a controllable thermal bath. Controllable couplings are also needed between qubits in order to perform quantum logic gates.

Fig. 2 illustrates schematically a situation in which the quantum computing system comprises a plurality of qubits 201, 202, 203, and 204. Controllable couplings may need to be made between arbitrary pairs of the qubits, while simultaneously keeping the other qubits unaffected to as large extent as possible. This may be particularly challenging in so-called grid addressing of qubits, in which the control signal lines constitute a grid with each qubit influenced by at least two separate control signal lines. In grid addressing, the control signal aimed at a particular qubit comes from the combined effect of the signals on respective at least two control signal lines, while all further qubits along each individual signal line should remain unaffected. It has been found, however, that even the lower-level effect of an individual control signal may cause unwanted crosstalk due to the fact that the blocking effect of couplings that should remain "off" is not sufficient.

Fig. 3 illustrates a case in which two so-called ancilla qubits 301 and 302 flank a qubit 303 used for actual computing. Ancilla qubits can be used for parity measurements as a part of quantum error correction. In particular if autonomous error correction can be utilized, readout of the ancilla qubits 301 and 302 is not necessary and only a simple unconditional high fidelity reset will be sufficient. This can be accomplished by controllably coupling the ancilla qubit to a respective QCR 304 or 305.

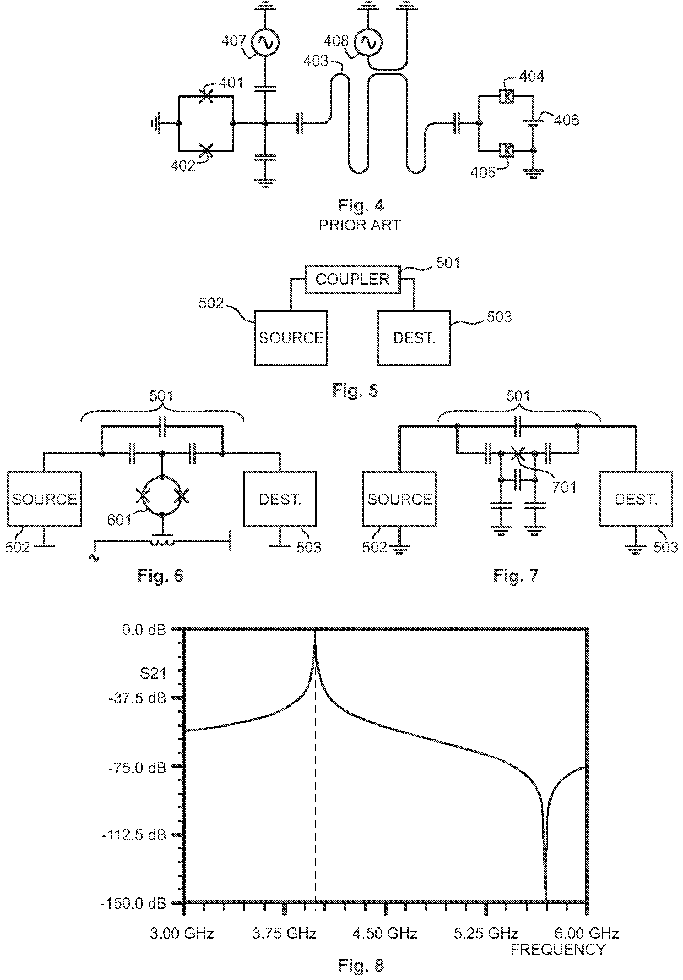

Fig. 4 illustrates a known way of using a coupler to initialize a qubit, as published in T. Yoshioka, J.S.Tsai: "Fast unconditional initialization for superconducting qubit and resonator using quantum-circuit refrigerator", Appl. Phys. Lett. 119, 124003 (2021). The qubit comprises a superconductive loop cut by two Josephson junctions 401 and 402. The coupler comprises a resonator 403 capacitively coupled to the qubit at one end and to a photon-absorbing circuit at the other end. The photon-absorbing circuit comprises two SIN (superconductor - insulator - normal metal) junctions 404 and 405 and a bias voltage source 406 in a loop, with the lower potential side of the bias voltage source 406 grounded. A first control signal source 407 can be used for excitation |e, 0> → |f, 0> and |f,0> → |g,1> of the qubit, transferring energy from the qubit to the resonator 403 as a part of the reset process. A second control signal source 408 can be used to perform readout operations using the resonator 403. While the circuit shown in fig. 4 can be successfully used for the unconditional reset of qubits, it involves the cost of continuous unwanted energy decay, which in turn has a disadvantageous effect on the thermal relaxation time T1 of the qubit. Having to go through the energy transfer process in order to do reset limits the speed of the reset.

Further disadvantageous effects of known couplings to qubits become more apparent in larger quantum computing systems, which call for miniaturizing all circuit hardware. Shorter distances between circuit elements often cause more difficult problems with unwanted crosstalk. Also, the smaller the circuit elements are the more difficult it is to make them accurately enough: inevitable variations in the manufacturing process often cause initial deviations from the desired frequency characteristics, which leads to increased need of laborious subsequent tuning.

A prior art document Chui-Ping Yang, Siyuan Han: Generating entanglement among microwave photons and qubits in multiple cavities coupled by a superconducting qubit, arXiv: 1106.3237v2 [quant-ph] 8 Jul 2011, discloses a method for generating entangled coherent states of four microwave resonators coupled by a superconducing qubit.

Another prior art document A.Messinger, B.G.Taketani, F.K.Wilhelm: Left-handed superlattice metamaterials for circuit-QED, arXiv:1810.03446v1 [quanti-ph] 8 Oct 2018 discloses a circuit-QED simulation of many-body Hamiltonians using superlattice metamaterials.

Another prior art document Hao Hsu et al.: Tunable refrigerator for non-linear quantum electric circuits, arXiv:2002.06867v2 [cond-mat.mes-hall] 16 Jun 2020 discloses a theoretical study of a quantum-circuit refrigerator in the case of non-linear quantum electric circuits such as superconducting qubits.

### SUMMARY

This summary is provided to introduce a selection of concepts in a simplified form that are further described below in the detailed description. This summary is not intended to identify key features or essential features of the claimed subject matter, nor is it intended to be used to limit the scope of the claimed subject matter.

It is an objective to provide an arrangement and a method for making a coupling to a qubit, and a quantum computing system. The coupling should exhibit a large difference in coupling strength between on and off states. The foregoing and other objectives are achieved by the features of the independent claims. Further implementation forms are apparent from the dependent claims, the description and the figures.

According to a first aspect, an arrangement for controllably coupling a qubit to another circuit element and for controllably decoupling the qubit from the other circuit element for performing quantum computing operations comprises said qubit and another circuit element. A network of resonators is provided between said qubit and said other circuit element for conveying the controllable coupling. The qubit is a superconducting qubit. Said network of resonators comprises a plurality of resonators, comprising linear or nonlinear resonators or both. At least two of said plurality of resonators have an identical circuit topology but different frequency responses. Said controllable coupling is conveyed on a frequency included in a passband of said network (901) of resonators.

According to an embodiment, said other circuit element is a quantum circuit refrigerator. This involves at least the advantage that the coupling through the network of resonators can be utilized very effectively for resetting the qubit.

According to an embodiment, said other circuit element is another qubit. This involves at least the advantage that the coupling through the network of resonators can be utilized to make desired pairs or groups of qubits interact with each other while effectively keeping other qubits from taking part in undesired interactions.

According to an embodiment, said network of resonators comprises said plurality of resonators coupled in series between said qubit and said other circuit element. This involves at least the advantage that the coupling can be designed relatively straightforwardly by duplicating the similar topology a desired number of times, without having to care about possible small variations caused by manufacturing tolerances.

According to an embodiment, there are at least six of said resonators coupled in series between said qubit and said other circuit element. This involves at least the advantage that advantageously wide passbands and/or stopbands can be achieved in the frequency response of the network of resonators.

According to an embodiment, each of said resonators comprises a capacitively shunted Josephson junction. This involves at least the advantage that at least some of the manufacturing steps used to produce said resonators may be the same or at least very similar to those used to manufacture other circuit elements, such as qubits, in the quantum computing system.

According to an embodiment, each of said resonators comprises a qubit. This involves at least the advantage that at least some of the manufacturing steps used to produce said resonators may be the same or at least very similar to those used to manufacture other circuit elements, such as computing qubits, in the quantum computing system.

According to an embodiment, said network of resonators comprises at least one serially coupled LC resonator as a part of the connection between said qubit and said other circuit element and at least one LC resonator between said connection and ground. This involves at least the advantage that the network of resonators can be made to have a wide range of various characteristics, while keeping its footprint on the substrate relatively small.

According to an embodiment, there may be three LC resonators between said connection and ground, of which one is coupled between a middle point of said serially coupled LC resonator and ground. This involves at least the advantage that the network of resonators can be constructed with good understanding of its possible frequency characteristics.

According to a second aspect, there is provided a quantum computing system, which comprised a plurality of qubits, at least one of which constitutes a part of an arrangement of a kind described above.

According to an embodiment, said plurality of qubits form an array. Each qubit in said array may then constitute a part of an arrangement of a kind described above, the qubits in said array constituting said other circuit elements to each other. This involves at least the advantage that a quantum computing system with even a very large number of qubits can be constructed, with advantageous coupling characteristics between the qubits.

According to an embodiment, said qubits in said array are addressable through a grid addressing scheme that involves a grid of addressing lines in at least two distinct directions through said array, so that combinations of control signals through said grid addressing scheme are configured to selectably define, which qubits in said array become coupled together through said network of resonators. This involves at least the advantage that only a relatively small number of control signals lines, i.e. addressing lines, are needed to control a large number of qubits.

According to a third aspect, there is provided a method for making a coupling to a qubit. The method comprises controllably coupling and decoupling said qubit with another circuit element for performing quantum computing operations and conveying said controllable coupling through a network of resonators between said qubit and said other circuit element. Said qubit is a superconducting qubit. Said network of resonators comprises a plurality of resonators, comprising linear or nonlinear resonators or both. At least two of said plurality of resonators have an identical circuit topology but different frequency responses. Said controllable coupling is conveyed on a frequency included in a passband of said network (901) of resonators.

According to an embodiment, said resonators are static resonators and said controllable coupling and decoupling are done by tuning the operating frequency of at least one of said qubit and said other circuit element. This involves at least the advantage that relatively simple structures are required for making the couplings.

According to an embodiment, among said plurality of resonators is at least one frequency-tunable resonator. Said controllable coupling and decoupling may then involve tuning the resonant frequency or frequencies of such at least one frequency-tunable resonator. This involves at least the advantage that more versatile systems can be build than with just static resonators.

### BRIEF DESCRIPTION OF THE DRAWINGS

In the following, example embodiments are described in more detail with reference to the attached figures and drawings, in which:
Fig. 1 illustrates two qubits, two QCR's, and their mutual couplings;
Fig. 2 illustrates four qubits and their mutual couplings;
Fig. 3 illustrates a computing qubit, two ancilla qubits, and two QCR's used to reset the ancilla qubits;
Fig. 4 illustrates a qubit, a resonator, and an energy absorption circuit;
Fig. 5 illustrates the principle of using a coupler between a qubit and another circuit element;
Fig. 6 illustrates an example of a coupler between a qubit and another circuit element;
Fig. 7 illustrates an example of a coupler between a qubit and another circuit element;
Fig. 8 illustrates an example of a frequency response of a coupler between a qubit and another circuit element;
Fig. 9 illustrates the principle of using a coupler network between a qubit and another circuit element;
Fig. 10 illustrates an example of a coupler network between a qubit and another circuit element;
Fig. 11 illustrates a comparison of frequency responses of a coupler and a coupler network between a qubit and another circuit element;
Fig. 12 illustrates an example of a coupler network between a qubit and another circuit element;
Fig. 13 illustrates the frequency responses of the arrangement in fig. 12 in two different instances;
Fig. 14 illustrates an example of a coupler network between a qubit and another circuit element;
Fig. 15 illustrates a comparison of frequency responses of a coupler and a coupler network between a qubit and another circuit element:
Fig. 16 illustrates an array of grid-addressable qubits and couplers between them.

### DETAILED DESCRIPTION

In the following description, reference is made to the accompanying drawings, which form part of the disclosure, and in which are shown, by way of illustration, specific aspects in which the present disclosure may be placed. It is understood that other aspects may be utilised, and structural or logical changes may be made without departing from the scope of the present disclosure. The following detailed description, therefore, is not to be taken in a limiting sense, as the scope of the present disclosure is defined be the appended claims.

For instance, it is understood that a disclosure in connection with a described method may also hold true for a corresponding device or system configured to perform the method and vice versa. For example, if a specific method step is described, a corresponding device may include a unit to perform the described method step, even if such unit is not explicitly described or illustrated in the figures. On the other hand, for example, if a specific apparatus is described based on functional units, a corresponding method may include a step performing the described functionality, even if such step is not explicitly described or illustrated in the figures. Further, it is understood that the features of the various example aspects described herein may be combined with each other, unless specifically noted otherwise.

Fig. 5 is a generalized schematic representation of a quantum circuit in which a coupler 501 can be used to selectively couple a source 502 of RF energy to a destination 503. For the purpose of the following description, the exact nature of the source 502 and destination 503 is not important, because the emphasis is on the selective nature of the coupling: a coupling, when established or in an "on" state, should be as effective as possible, while the "off" state of the coupling should block the transmission of RF energy in a frequency range of interest as effectively as possible. In many cases, for the purpose of illustrative example, the source 502 can be considered a qubit. The destination 503 may be for example another qubit, or a QCR, or some other circuit element to which the source 502 is to be selectively coupled using the coupler 501.

Making the coupling selective may involve using a tunable coupler between a fixed-frequency source and a fixed-frequency destination. Also a so-called parked-frequency source or parked-frequency destination may be considered "fixed-frequency" in this respect; parking means deliberately maintaining a circuit element on a selected resonance frequency even if it could be tuned to a different resonance frequency if wanted. Alternatively, the coupler may have fixed-frequency properties so that making the coupling selective may involve tuning at least one of the source and the destination. It is also possible that the source, coupler, and destination are all tunable. The system of a source, coupler, and destination may be evaluated in terms of a frequency response of the coupling. Such a frequency response may involve a pass band, the center frequency of which is the one at which the coupling is its most efficient. Similarly, the frequency response may involve a stop band, the center frequency of which is the one at which the coupling most effectively blocks the propagation of RF energy.

Figs. 6 and 7 show examples of couplers that can be used to realize an arrangement like that in fig. 5. The coupler in fig. 6 is a so-called MIT style coupler, in which a flux qubit 601 is connected to the middle point of a capacitively shunted series chain of two capacitive elements. A tuning signal through a nearby inductance creates a magnetic flux that induces a compensating current in the flux qubit 601, creating a superposition of the clockwise and counter-clockwise loop currents, which in turn changes the overall resonant properties of the coupler 501. In fig. 7 the coupler 501 is implemented as a capacitively shunted Josephson junction 701.

Fig. 8 is an example of a frequency response of a coupling implemented with a known coupler according to the principle shown in fig. 5. The graph in fig. 8 shows the S21 parameter value of the coupling from source to destination as a function of frequency. The significance of the S21 parameter value in evaluating the efficiency of the coupling can be illustrated by considering both the source and the destination as qubits. The coupling rate (i.e. how long it takes for two qubits to exchange population of microwave quanta) scales proportional to |S21| rather than |S21|^2, particularly for small values. There is some levelling off for large values in comparison to |S21|. While that does not change the principal picture, it may prove advantageous to design the couplers as going a bit deeper than if the levelling of did not occur, in order to compensate for the levelling. For practical controllable couplings, one needs rather deep off states. If the on-state were to have a coupling rate of 50 MHz, to reach a coupling rate of 1 Hz in the off-state, one would expect to need S21 to go down approximately -150 dB from the corresponding on state value.

In fig. 8 the on-state occurs at approximately 3.98 GHz and the off-state at about 5.69 GHz. However, both the on-state frequency band and (in particular) the off-state frequency band have the form of a very sharp peak in fig. 8, which means that very exact tuning to the intended frequencies is required. Couplers like those in figs. 6 and 7 are called narrowband couplers for this reason.

Here the difficulties mentioned in the description of prior art may be recalled. If the physical dimensions of the quantum circuit elements are to be made smaller, it becomes increasingly more difficult to manufacture said quantum circuit elements accurately enough to consistently achieve the required exactness in frequency characteristics, particularly if a large number of quantum circuit elements should be manufactured on a common substrate.

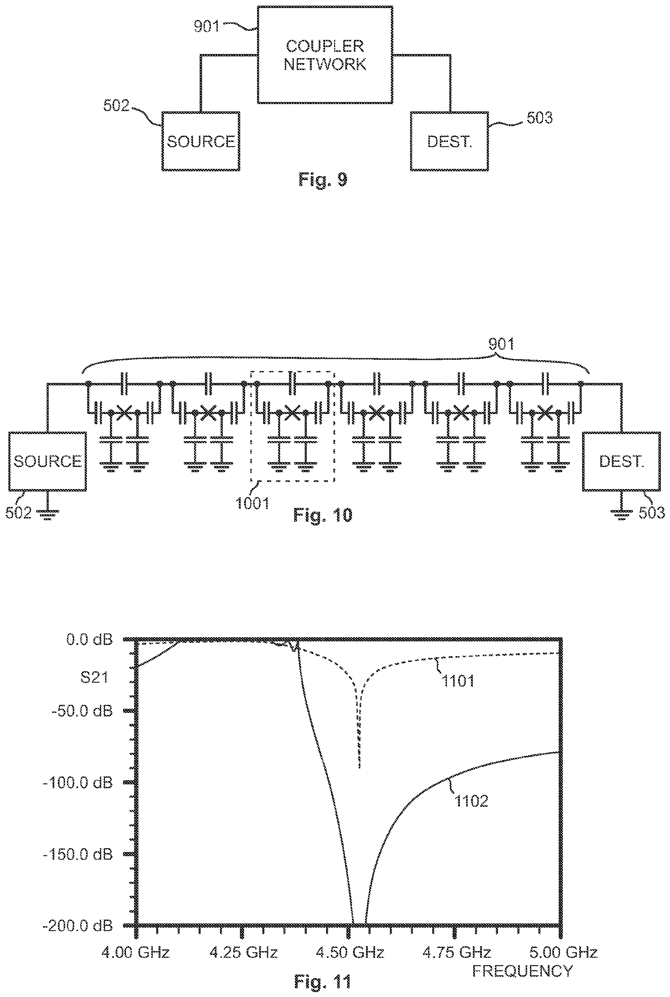

Fig. 9 shows schematically an arrangement for making a coupling to a source 502, which may be a qubit. As in fig. 5, the element shown as the destination 503 is another circuit element, which is to be controllably coupled to the qubit (or source 502) and decoupled therefrom for performing quantum computing operations. Instead of a single coupler like in fig. 5, the arrangement of fig. 9 comprises a coupler network 901 between the source 502 and the destination 503. The coupler network 901 consists of a network of resonators between the source 502 and the destination 503. The network of resonators comprises a plurality of resonators, comprising linear or nonlinear resonators or both. At least two of said plurality of resonators have an identical circuit topology but different frequency responses.

The difficulty of prior art mentioned above is in a way turned into an advantage in fig. 9. As it is difficult to manufacture two resonators - that based on their circuit topology should be exactly the same - so that their frequency response was the same, their frequency responses are intentionally allowed to differ in fig. 9. It has been found that the naturally occurring variation in frequency characteristics caused by statistical variation in the manufacturing process may lead to the network of resonators having a more advantageous frequency response than any of its individual resonators if used as couplers. Together, the resonators in the network may constitute a so-called wideband coupler, examples of which are described in more detail below.

Fig. 10 illustrates an example of applying the principle shown in fig. 9. In the arrangement of fig. 10, the coupler network 901 between the source 502 and the destination 503 comprises six couplers of the kind shown in fig. 7 coupled in series. One of said six couplers is singled out in fig. 10 with the reference designator 1001 for the purpose of illustration. Each of said couplers is a resonator of its own, so fig. 10 essentially shows a network of (serially coupled) resonators between the source (or qubit) 502 and the destination (or other circuit element) 503. In the embodiment of fig. 10, each of the resonators comprises a capacitively shunted Josephson junction.

Fig. 11 shows the frequency responses - represented as the S21 parameter value as a function of frequency - of couplings made with the narrowband single-resonator coupler 501 of fig. 7 (graph 1101) and with the wideband six-resonator coupler network 901 of fig. 10 (graph 1102). Both have a wide passband centred around approximately 4.25 GHz and a narrower stopband centred around approximately 4.53 GHz. However, the upper edge of the passband in graph 1102 at approximately 4.38 GHz drops much more steeply and the stopband goes much deeper and is much wider than that of graph 1101. This shows that while the wideband six-resonator coupler network 901 of fig. 10 provides a very effective coupling at the passband frequencies, it also blocks very effectively all unwanted transmission of RF energy on the stopband frequencies. Additionally, the nominal stop frequency of the wideband six-resonator coupler network 901 of fig. 10 does not need to hit any unwanted resonance frequency (for example that of a nearby qubit that should not currently be coupled anywhere) particularly accurately compared to what the similar requirement would be if the coupling was made with the narrowband single-resonator coupler 501 of fig. 7.

The significant width of the stopband of the six-resonator coupler network 901 of fig. 10, represented by the deep valley in graph 1102, is also useful if there are a plurality of unwanted resonance frequencies on which no coupling should be currently made, as long as all such unwanted resonance frequencies are close enough to each other to fit within a useful width of the stopband in graph 1102.

The number of resonators coupled in series between the source and the destination has an effect on the width of the stopband and the steepness of the band edges in the frequency response. In an advantageous embodiment, as in fig. 10, there are at least six resonators coupled in series between the source 502 and the destination 503.

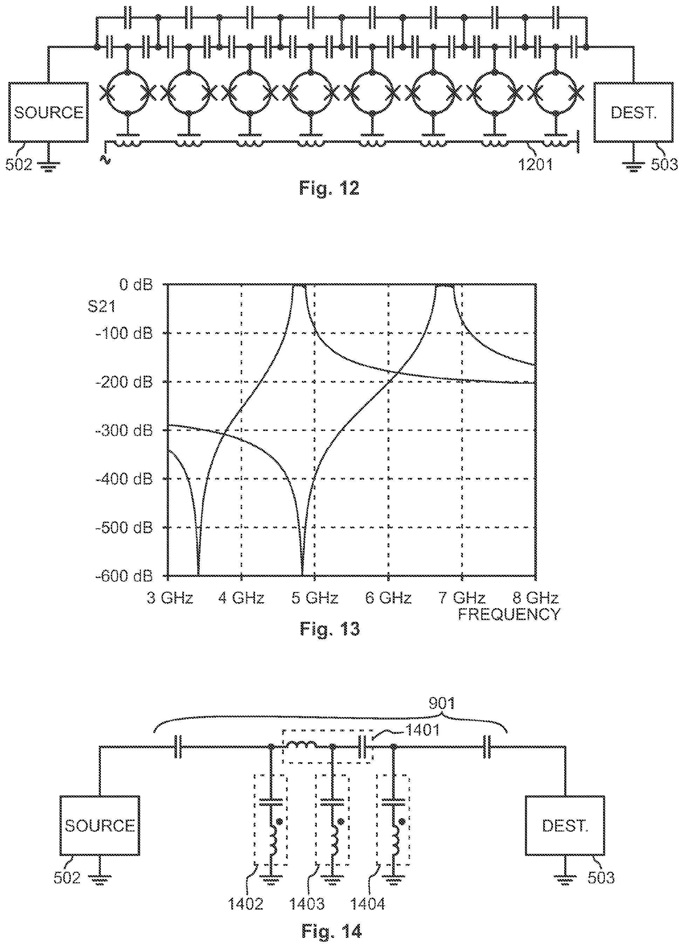

Fig. 12 illustrates another embodiment in which the coupler network 901 comprises a network of resonators coupled in series between the source 502 and the destination 503. In this embodiment, each of the resonators comprises a qubit; in particular, each of the resonators is a so-called MIT style coupler in which a flux qubit is connected to the middle point of a capacitively shunted series chain of two capacitive elements. In the embodiment of fig. 12, there are eight resonators coupled in series between the source 502 and the destination 503. A common control signal line 1201 can be used to simultaneously tune all eight resonators.

Fig. 13 shows the frequency responses - represented as the S21 parameter value as a function of frequency - of a coupling made with the wideband eight-resonator coupler network 901 of fig. 12 at two different values of the control signal. In both cases there is a relatively wide passband, the edges of which drop steeply enough below at least the -100 dB level and relatively steeply even below the -150 dB level to efficiently block couplings on unwanted resonance frequencies. The value of the S21 parameter stays close enough to 0 dB throughout the passband, which is more than 100 MHz wide.

Other forms of resonators can be used in the coupler network than those shown above in figs. 10 and 12. Fig. 14 illustrates an embodiment in which the network of resonators in the coupler network 901 comprises at least one serially coupled LC resonator 1401 as a part of the connection between the source 502 and the destination 503 and at least one LC resonator between said connection and ground. In the embodiment of fig. 14, there are three of said LC resonators 1402, 1403, and 1404 between said connection and ground.

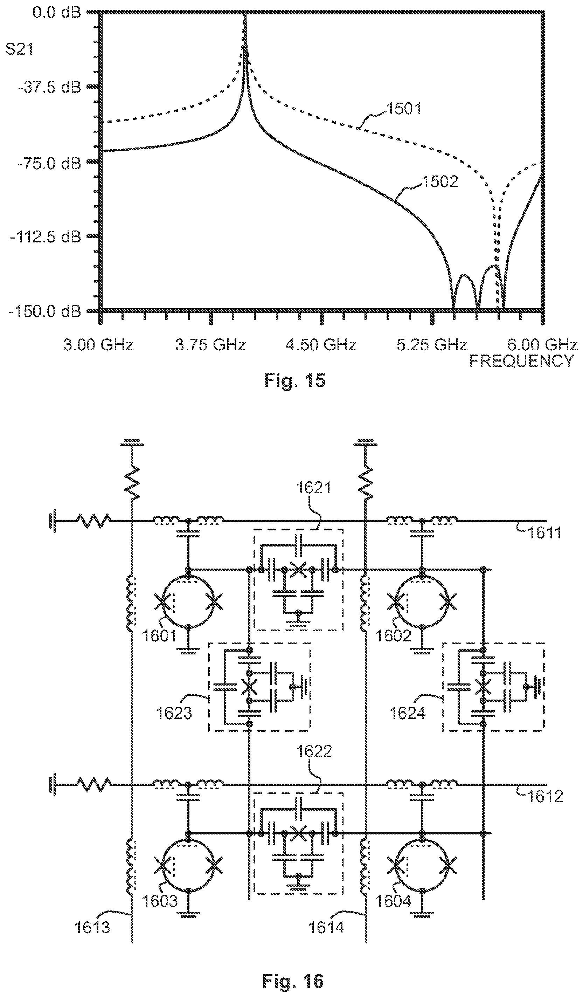

Fig. 15 shows a comparison of frequency responses - represented as the S21 parameter value as a function of frequency - of couplings made with a narrowband single-resonator coupler (graph 1501) and with the wideband four-resonator coupler network 901 of fig. 14 (graph 1502). Again, it can be seen that achieving the desired combination of a passband and a stopband is easier with the wideband coupler, but still not entirely trivial, especially if only a small number of certain types of elements are available, for example due to fabrication issues. For example, in Fig. 15 the desired S21 parameter value -150 dB is not quite reached for the intended stopband but would probably require one more resonator or accepting a narrower band. It should be noted, though, that even two distinct "off" frequencies with somewhat insufficient off-state in between can be useful for the wideband coupler, because the "spectator qubits" or other circuit elements to which no coupling should currently be made can sit in these two "off" frequencies most of the critical time even if they must quickly pass through the less than ideal frequencies.

In the examples above, the coupling through a network of resonators was described between a source and a destination. As already suggested above, the source may be a qubit and the destination may be for example a QCR. In such a case, controllably coupling the qubit to the QCR can be used for unconditionally resetting the qubit. As another example, the destination may be a controllable thermal bath, in which case the controllable coupling may be used to initialise the qubit to a thermal state by coupling it to the controllable thermal bath.

A similar controllable coupling through a network of resonators may also be used between two (or more) qubits in order to perform quantum computing gates. In general, a quantum computing system may comprise a plurality of qubits, at least one of which constitutes a part of an arrangement of the kind described above. As a specific example, a quantum computing system according to an embodiment is described next with reference to fig. 16.

In fig. 16, a plurality of qubits that belong to a quantum computing system form an array. Each of said qubits 1601, 1602, 1603, and 1604 shown in fig. 16 is a transmon; also other types of qubits could be employed. Shunt capacitors are omitted in fig. 16 to simplify the graphical representation. Each qubit in the array constitutes a part of an arrangement of the kind described above, so that the qubits 1601, 1602, 1603, and 1604 in the array constitute the "other circuit elements" to each other. In other words, controllable couplings through a network of resonators can be formed between desired pairs of qubits in the array.

In the embodiment of fig. 16, the qubits are tunable, i.e. addressable through a grid addressing scheme that involves a grid of addressing lines. In this embodiment, the addressing lines go in two distinct directions: see addressing lines 1611 and 1612 in the horizontal direction and addressing lines 1613 and 1614 in the vertical direction. It is possible to provide grids of addressing lines that go through the array in more than two distinct directions. According to the basic idea of grid addressing, combinations of control signals through the addressing lines of the grid addressing scheme are used to interact with the qubits. For example, a control signal of small magnitude solely through the upper horizontal addressing line 1611 or solely through the left vertical addressing line 1613 would not cause significant interaction with any of qubits 1601, 1602, or 1603 even if these are located along said addressing lines (although some smaller, unintended interaction cannot be completely avoided) . Simultaneously directing control signals of such small magnitude through both addressing lines 1611 and 1613 causes a combination of control signals at the top left qubit 1601 that is strong enough to cause the desired interaction with the qubit.

In addition to the qubits, the quantum computing system of fig. 16 comprises resonators between the qubits. Here, we may first consider what happens in the quantum computing system when the resonators are single resonators of the type shown earlier in figs. 7 and 10, constituting narrowband couplers between the qubits. As an example, we may assume that resonator 1621 is utilized to couple qubits 1601 and 1602, by tuning said qubits to match the on-frequency of the resonator 1621. A combination of control signals through addressing lines 1611 and 1613 is used to tune qubit 1601, and a combination of control signals through addressing lines 1611 and 1613 is used to tune qubit 1602. Qubits 1603 and 1604 should not be affected; however, some lesser extent of interaction will inevitably take place. The control signal of small magnitude through addressing line 1613 will partially tune qubit 1603, and the same will happen between addressing line 1614 and qubit 1604. Taken that the resonators 1621, 1622, 1623, and 1624 are narrowband couplers, the partial tuning of qubits 1613 and 1614 will probably move them out of the narrow off-frequency peak in the frequency response of at least some of the resonators 1622, 1623, and 1624, causing unintended interactions between pairs of qubits in the quantum computing system.

As an alternative, it may be assumed that each possible coupling between a pair of qubits could go through resonators that constitute a network. For example, the resonator shown as 1621 and constituting a narrowband coupler in fig. 16 could be replaced with a network of resonators that followed the general approach shown in fig. 10 or fig. 14 for example. Combinations of control signals through the addressing lines could again be used to selectively tune desired pairs of qubits into resonance on a known passband of the corresponding resonator network, while keeping other qubits of the array on one or more frequencies that coincide with one or more stopbands of the resonator network. In such an embodiment, the combinations of control signals through the addressing lines would be configured to selectably define, which qubits in the array become coupled together through a network of resonators.

Compared to solutions with only single narrowband couplers between qubits, in a modified quantum computing system like that described above the off-states of couplings may be made much wider in frequency and deeper in coupling-blocking capability. This is advantageous, because - as mentioned above already - despite the aim of not interacting with "spectator" qubits with the low levels of individual control signals, some unintentional detuning still occurs, moving the affected qubits away from the exact resonance frequencies at which they would be in the complete absence of any control signals. The wider stopband may be more effective to cover also such slightly detuned frequencies of spectator qubits.

Any range or device value given herein may be extended or altered without losing the effect sought. Also any embodiment may be combined with another embodiment unless explicitly disallowed.

Although the subject matter has been described in language specific to structural features and/or acts, it is to be understood that the subject matter defined in the appended claims is not necessarily limited to the specific features or acts described above. Rather, the specific features and acts described above are disclosed as examples.

It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item may refer to one or more of those items.

The steps of the methods described herein may be carried out in any suitable order, or simultaneously where appropriate.

The term 'comprising' is used herein to mean including the method, blocks or elements identified, but that such blocks or elements do not comprise an exclusive list and a method or apparatus may contain additional blocks or elements.

## Claims

1. An arrangement for controllably coupling a qubit (502) to another circuit element (503) and for controllably decoupling the qubit (502) from the other circuit element (503) for performing quantum computing operations, comprising:
- said qubit (502),
- the other circuit element (503), and
- a network (901) of resonators between said qubit (502) and said other circuit element (503) for conveying said controllable coupling;
wherein said qubit (502) is a superconducting qubit, wherein said network (901) of resonators comprises a plurality of resonators (1001, 1401, 1402, 1403, 1404), comprising linear or nonlinear resonators or both,
wherein at least two of said plurality of resonators (1001, 1401, 1402, 1403, 1404) have an identical circuit topology but different frequency responses, and
**characterized in that**
said controllable coupling is conveyed on a frequency included in a passband of said network (901) of resonators.

2. An arrangement according to claim 1, wherein said other circuit element (503) is a quantum circuit refrigerator.

3. An arrangement according to claim 1, wherein said other circuit element (503) is another superconducting qubit.

4. An arrangement according to any of claims 1 to 3, wherein said network of resonators comprises said plurality of resonators (1001) coupled in series between said qubit (502) and said other circuit element (503).

5. An arrangement according to claim 4, wherein there are at least six of said resonators (1001) coupled in series between said qubit (502) and said other circuit element (503).

6. An arrangement according to any of claims 4 or 5, wherein each of said resonators (1001) comprises a capacitively shunted Josephson junction.

7. An arrangement according to any of claims 4 or 5, wherein each of said resonators comprises a superconducting qubit.

8. An arrangement according to any of claims 1 to 3, wherein said network of resonators comprises at least one serially coupled LC resonator (1401) as a part of the connection between said qubit (502) and said other circuit element (503) and at least one LC resonator (1402, 1403, 1404) between said connection and ground.

9. An arrangement according to claim 8, comprising three LC resonators (1402, 1403, 1404) between said connection and ground, of which one (1403) is coupled between a middle point of said serially coupled LC resonator (1401) and ground.

10. A quantum computing system, comprising a plurality of superconducting qubits (1601, 1602, 1603, 1604), at least one of which constitutes a part of an arrangement according to any of claims 1 to 9.

11. A quantum computing system according to claim 10, wherein:
- said plurality of superconducting qubits (1601, 1602, 1603, 1604) form an array, and
- each superconducting qubit in said array constitutes a part of an arrangement according to any of claims 1 to 7, the superconducting qubits in said array constituting said other circuit elements to each other.

12. A quantum computing system according to claim 11, wherein:
- said superconducting qubits (1601, 1602, 1603, 1604) in said array are addressable through a grid addressing scheme that involves a grid of addressing lines (1611, 1612) in at least two distinct directions through said array, so that combinations of control signals through said grid addressing scheme are configured to selectably define, which superconducting qubits (1601, 1602, 1603, 1604) in said array become coupled together through said network of resonators.

13. A method for making a coupling to a qubit (502), comprising:
- controllably coupling and decoupling said qubit (502) with another circuit element (503) for performing quantum computing operations, and
- conveying said controllable coupling through a network (901) of resonators between said qubit (502) and said other circuit element (503);
wherein said qubit (502) is a superconducting qubit, wherein said network (901) of resonators comprises a plurality of resonators (1001, 1401, 1402, 1403, 1404), comprising linear or nonlinear resonators or both,
wherein at least two of said plurality of resonators (1001, 1401, 1402, 1403, 1404) have an identical circuit topology but different frequency responses, and **characterized in that** said controllable coupling is conveyed on a frequency included in a passband of said network (901) of resonators.

14. A method according to claim 13, wherein said resonators (1001, 1401, 1402, 1403, 1404) are static resonators and said controllable coupling and decoupling are done by tuning the operating frequency of at least one of said qubit (502) and said other circuit element (503).

15. A method according to claim 13, wherein among said plurality of resonators (1001, 1401, 1402, 1403, 1404) is at least one frequency-tunable resonator, and said controllable coupling and decoupling involve tuning the resonant frequency or frequencies of such at least one frequency-tunable resonator.

## Patentansprüche

1. Anordnung zur steuerbaren Kopplung eines Qubits (502) an ein anderes Schaltungselement (503) und zur steuerbaren Entkopplung des Qubits (502) von dem anderen Schaltungselement (503) zur Durchführung von Quantenberechnungsoperationen, umfassend:
- das Qubit (502),
- das andere Schaltungselement (503), und
- ein Netzwerk (901) von Resonatoren zwischen dem Qubit (502) und dem anderen Schaltungselement (503) zur Vermittlung der steuerbaren Kopplung;
wobei das Qubit (502) ein supraleitendes Qubit ist, wobei das Netzwerk (901) von Resonatoren eine Mehrzahl von Resonatoren (1001, 1401, 1402, 1403, 1404) umfasst, umfassend lineare oder nichtlineare Resonatoren oder beides,
wobei wenigstens zwei von der Mehrzahl von Resonatoren (1001, 1401, 1402, 1403, 1404) eine identische Schaltungstopologie, aber verschiedene Frequenzantworten haben, und **dadurch gekennzeichnet, dass**
die steuerbare Kopplung auf einer Frequenz vermittelt wird, die in einem Durchlassband des Netzwerks (901) von Resonatoren enthalten ist.

2. Anordnung nach Anspruch 1, wobei das andere Schaltungselement (503) ein Quantenschaltungskühlschrank ist.

3. Anordnung nach Anspruch 1, wobei das andere Schaltungselement (503) ein anderes supraleitendes Qubit ist.

4. Anordnung nach einem der Ansprüche 1 bis 3, wobei das Netzwerk von Resonatoren die Mehrzahl von Resonatoren (1001) umfasst, die in Reihe zwischen dem Qubit (502) und dem anderen Schaltungselement (503) gekoppelt sind.

5. Anordnung nach Anspruch 4, wobei wenigstens sechs von den Resonatoren (1001) vorgesehen sind, die in Reihe zwischen dem Qubit (502) und dem anderen Schaltungselement (503) gekoppelt sind.

6. Anordnung nach einem der Ansprüche 4 oder 5, wobei jeder von den Resonatoren (1001) einen kapazitiv geshunteten Josephson-Übergang umfasst.

7. Anordnung nach einem der Ansprüche 4 oder 5, wobei jeder von den Resonatoren ein supraleitendes Qubit umfasst.

8. Anordnung nach einem der Ansprüche 1 bis 3, wobei das Netzwerk von Resonatoren wenigstens einen seriell gekoppelten LC-Resonator (1401) als Teil der Verbindung zwischen dem Qubit (502) und dem anderen Schaltungselement (503) und wenigstens einen LC-Resonator (1402, 1403, 1404) zwischen der Verbindung und Erde umfasst.

9. Anordnung nach Anspruch 8, umfassend drei LC-Resonatoren (1402, 1403, 1404) zwischen der Verbindung und Erde, von denen einer (1403) zwischen einen Mittelpunkt des seriell gekoppelten LC-Resonators (1401) und Erde gekoppelt ist.

10. Quantencomputersystem, umfassend eine Mehrzahl von supraleitenden Qubits (1601, 1602, 1603, 1604), von denen wenigstens eines einen Teil einer Anordnung nach einem der Ansprüche 1 bis 9 bildet.

11. Quantencomputersystem nach Anspruch 10, wobei:
- die Mehrzahl von superleitenden Qubits (1601, 1602, 1603, 1604) ein Array bilden, und
- jedes supraleitende Qubit in dem Array einen Teil einer Anordnung nach einem der Anspruche 1 bis 7 bildet, wobei die supraleitenden Qubits in dem Array gegenseitig die anderen Schaltungselemente bilden.

12. Quantencomputersystem nach Anspruch 11, wobei:
- die supraleitenden Qubits (1601, 1602, 1603, 1604) im dem Array durch ein Gitteradressierschema adressierbar sind, das ein Gitter von Adressierungsleitungen (1611, 1612) in wenigstens zwei verschiedenen Richtungen durch das Array beinhaltet, so dass Kombinationen von Steuersignalen durch das Gitteradressierungsschema dazu konfiguriert sind, selektierbar zu definieren, welche supraleitenden Qubits (1601, 1602, 1062, 1604) in dem Array durch das Netzwerk von Resonatoren miteinander gekoppelt werden.

13. Verfahren zur Herstellung einer Kopplung an ein Qubit (502), umfassend:
- steuerbares Koppeln und Entkoppeln des Qubits (502) mit einem anderen Schaltungselement (503) zur Durchführung von Quantenberechnungsoperationen, und
- Vermitteln der steuerbaren Kopplung durch ein Netzwerk (901) von Resonatoren zwischen dem Qubit (502) und dem anderen Schaltungselement (503);
wobei das Qubit (502) ein supraleitendes Qubit ist, wobei das Netzwerk (901) von Resonatoren eine Mehrzahl von Resonatoren (1001, 1401, 1402, 1403, 1404) umfasst, umfassend lineare oder nichtlineare Resonatoren oder beides,
wobei wenigstens zwei von der Mehrzahl von Resonatoren (1001, 1401, 1402, 1403, 1404) eine identische Schaltungstopologie, aber verschiedene Frequenzantworten haben, und **dadurch gekennzeichnet, dass** die steuerbare Kopplung auf einer Frequenz vermittelt wird, die in einem Durchlassband des Netzwerks (901) von Resonatoren enthalten ist.

14. Verfahren nach Anspruch 13, wobei die Resonatoren (1001, 1401, 1402, 1403, 1404) statische Resonatoren sind, und die steuerbare Kopplung und Entkopplung durch Abstimmung der Betriebsfrequenz des Qubits (502) und/oder des anderen Schaltungselements (503) erfolgt.

15. Verfahren nach Anspruch 13, wobei unter der Mehrzahl von Resonatoren (1001, 1401, 1402, 1403, 1404) wenigstens ein frequenz-abstimmbarer Resonator ist, und das steuerbare Koppeln und Entkoppeln eine Abstimmung der Resonanzfrequenz oder -frequenzen des wenigstens einen frequenz-abstimmbaren Resonators beinhaltet.

## Revendications

1. Agencement pour coupler de manière commandable un bit quantique (502) à un autre élément (503) de circuit et pour découpler de manière commandable le bit quantique (502) de l'autre élément (503) de circuit pour effectuer des opérations de calcul quantique, comprenant :
- ledit bit quantique (502),
- l'autre élément (503) de circuit, et
- un réseau (901) de résonateurs entre ledit bit quantique (502) et ledit autre élément (503) de circuit pour transporter ledit couplage commandable ;
dans lequel ledit bit quantique (502) est un bit quantique supraconducteur, dans lequel ledit réseau (901) de résonateurs comprend une pluralité de résonateurs (1001, 1401, 1402, 1403, 1404), comprenant des résonateurs linéaires ou non linéaires ou les deux,
dans lequel au moins deux de ladite pluralité de résonateurs (1001, 1401, 1402, 1403, 1404) présentent une topologie de circuit identique mais des réponses en fréquence différentes, et
**caractérisé en ce que**
ledit couplage commandable est transporté sur une fréquence incluse dans une bande passante dudit réseau (901) de résonateurs.

2. Agencement selon la revendication 1, dans lequel ledit autre élément (503) de circuit est un réfrigérateur à circuit quantique.

3. Agencement selon la revendication 1, dans lequel ledit autre élément (503) de circuit est un autre bit quantique supraconducteur.

4. Agencement selon l'une quelconque des revendications 1 à 3, dans lequel ledit réseau de résonateurs comprend ladite pluralité de résonateurs (1001) couplés en série entre ledit bit quantique (502) et ledit autre élément (503) de circuit.

5. Agencement selon la revendication 4, dans lequel il y a au moins six desdits résonateurs (1001) couplés en série entre ledit bit quantique (502) et ledit autre élément (503) de circuit.

6. Agencement selon l'une quelconque des revendications 4 ou 5, dans lequel chacun desdits résonateurs (1001) comprend une jonction Josephson capacitivement shuntée.

7. Agencement selon l'une quelconque des revendications 4 ou 5, dans lequel chacun desdits résonateurs comprend un bit quantique supraconducteur.

8. Agencement selon l'une quelconque des revendications 1 à 3, dans lequel ledit réseau de résonateurs comprend au moins un résonateur LC (1401) couplé en série en tant que partie de la connexion entre ledit bit quantique (502) et ledit autre élément (503) de circuit et au moins un résonateur LC (1402, 1403, 1404) entre ladite connexion et la masse.

9. Agencement selon la revendication 8, comprenant trois résonateurs LC (1402, 1403, 1404) entre ladite connexion et la masse, dont l'un (1403) est couplé entre un point médian dudit résonateur LC (1401) couplé en série et la masse.

10. Système de calcul quantique, comprenant une pluralité de bits quantiques (1601, 1602, 1603, 1604) supraconducteurs, dont au moins un constitue une partie d'un agencement selon l'une quelconque des revendications 1 à 9.

11. Système de calcul quantique selon la revendication 10, dans lequel :
- ladite pluralité de bits quantiques (1601, 1602, 1603, 1604) supraconducteurs forme un réseau, et
- chaque bit quantique supraconducteur dans ledit réseau constitue une partie d'un agencement selon l'une quelconque des revendications 1 à 7, les bits quantiques supraconducteurs dans ledit réseau constituant lesdits autres éléments de circuit les uns pour les autres.

12. Système de calcul quantique selon la revendication 11, dans lequel :
- lesdits bits quantiques (1601, 1602, 1603, 1604) supraconducteurs dans ledit réseau sont adressables à travers un schéma d'adressage en grille qui implique une grille de lignes (1611, 1612) d'adressage dans au moins deux directions distinctes à travers ledit réseau, de sorte que des combinaisons de signaux de commande à travers ledit schéma d'adressage en grille soient configurées pour définir sélectivement quels bits quantiques (1601, 1602, 1603, 1604) supraconducteurs dans ledit réseau deviennent couplés ensemble à travers ledit réseau de résonateurs.

13. Procédé de réalisation d'un couplage à un bit quantique (502), comprenant :
- le couplage et le découplage de manière commandable dudit bit quantique (502) avec un autre élément (503) de circuit pour effectuer des opérations de calcul quantique, et
- le transport dudit couplage commandable à travers un réseau (901) de résonateurs entre ledit bit quantique (502) et ledit autre élément (503) de circuit ;
dans lequel ledit bit quantique (502) est un bit quantique supraconducteur, dans lequel ledit réseau (901) de résonateurs comprend une pluralité de résonateurs (1001, 1401, 1402, 1403, 1404), comprenant des résonateurs linéaires ou non linéaires ou les deux,
dans lequel au moins deux de ladite pluralité de résonateurs (1001, 1401, 1402, 1403, 1404) présentent une topologie de circuit identique mais des réponses en fréquence différentes, et **caractérisé en ce que** ledit couplage commandable est transporté sur une fréquence incluse dans une bande passante dudit réseau (901) de résonateurs.

14. Procédé selon la revendication 13, dans lequel lesdits résonateurs (1001, 1401, 1402, 1403, 1404) sont des résonateurs statiques et lesdits couplage et découplage commandables sont faits par accord de la fréquence de fonctionnement d'au moins l'un parmi dudit bit quantique (502) et dudit autre élément (503) de circuit.

15. Procédé selon la revendication 13, dans lequel parmi ladite pluralité de résonateurs (1001, 1401, 1402, 1403, 1404) se trouve au moins un résonateur accordable en fréquence, et lesdits couplage et découplage commandables impliquent l'accord de la fréquence ou des fréquences de résonance d'un tel au moins un résonateur accordable en fréquence.
